# EUROPEAN PATENT SPECIFICATION

(11) **EP 2 082 630 B1**
(45) Date of publication and mention of the grant of the patent: **25.01.2012**
(21) Application number: 07830129.8
(22) Date of filing: 12.10.2007
(51) Int. Cl.: H05K 3/34, B23K 3/06

(54) **SLURRY DISCHARGE DEVICE**
SCHLÄMMENABGABEEINRICHTUNG
DISPOSITIF DE CHARGE DE BOUE

(30) Priority: 17.10.2006 JP 2006282328
(43) Date of publication of application: 29.07.2009
(60) Divisional application: 10006438.5
(73) Proprietor: Showa Denko K.K., Tokyo 105-8518 (JP)
(72) Inventor: SHOJI, Takashi, Minato-ku Tokyo 105-8518 (JP); SAKAI, Takekazu, Minato-ku Tokyo 105-8518 (JP)
(74) Representative: Strehl Schübel-Hopf & Partner
(86) International application number: PCT/JP2007/070395
(87) International publication number: WO 2008/047888

(56) References cited:
- WO-A1-86/00842
- WO-A1-2006/104238
- JP-A- 03 000 152
- JP-A- 2006 136 935
- JP-A- 2006 278 650
- US-A- 4 572 103

## Description

### Technical Field:

This invention relates to a device for discharging solder powder-containing slurry to be used for a method for forming a soldered circuit board.

### Background Art:

In recent years, a printed-wiring board having a circuit pattern formed on an insulating substrate, such as plastic substrate, ceramic substrate or plastic-coated metallic substrate has been developed and a means to configure electronic circuits by having electronic parts, such as IC elements, semiconductor chips, resistors and capacitors, soldered on the circuit pattern of the printed-wiring board has been finding extensive acceptance.

In this case, for the purpose of joining the lead terminals of the electronic parts to stated positions of the circuit pattern, the generally adopted practice comprises forming a thin solder layer in advance on the surface of a conductive circuit on the substrate, printing solder paste or flux, positioning and mounting prescribed electronic parts and then soldering them by reflowing the thin solder layer or the thin solder layer and solder paste.

Recently, for the purpose of miniaturizing electronic products, the soldered circuit boards are required to pursue the trend toward fine pitching and have been copiously mounting thereon 0.3 mm-pitch QFP (quad flat package) type and CSP (chip size package) type LSI packages and 0.15 mm-pitch FCs (flip chips). As a result, the soldered circuit boards are required to have a fine soldered circuit pattern capable of answering the fine pitching.

For the purpose of forming a soldered circuit via a solder film on a printed-wiring board, the plating method, HAL (hot air leveler) method or method which comprises printing paste of solder powder and reflowing the resultant print, for example, is carried out. The method for producing the soldered circuit by the plating method, however, incurs difficulty in adding to the thickness of the solder layer and the method resorting to the printing of solder paste incurs difficulty in coping with the fine pitch pattern.

As a way of forming a soldered circuit without requiring any complicated procedure as positioning a circuit pattern, therefore, a method has been disclosed, which method comprises reacting the surface of a conductive circuit on a printed-wiring board with a tackifier compound to impart tackiness to the surface, attaching solder powder to the resultant tacky part and then heating the printed-wiring board to fuse the solder powder, thereby forming a soldered circuit (refer, for example, to JP-A HEI 7-7244).

The method disclosed in JP-A HEI 7-7244 renders it possible to form a fine soldered circuit pattern by a simple procedure and consequently provide a circuit board of high reliability. Since this method causes solder powder to adhere by a dry process to the circuit board, it entails such problems as suffering the powder to adhere even to undue parts electrostatically, inducing the power to scatter, impeding miniaturization of the circuit board and disabling efficient use of the solder powder. The present inventors have applied for a patent of the invention directed to a method that comprises immersing a printed-wiring board in slurry containing solder powder and causing solder powder to adhere by a wet process to the tacky surface of a conductive circuit (refer, for example, to JP-A 2006-278650).

In the case of the method that comprises immersing a printed-wiring board in slurry containing solder powder and causing the solder powder to adhere by a wet process to the tacky surface of a conductive circuit, however, since the solder powder is subjected to buoyancy in the slurry, it manifests a weak adhesion force as compared with the dry process. To cope with this problem, a method that comprises using a device for discharging slurry containing solder powder, exerting pressure to the slurry and consequently causing the solder powder to adhere fast to the resultant tacky circuit part is conceivable. This method, however, entails the problem that the solder powder in the slurry is crushed with a machine part, such as a pump, in the discharge device and the solder powder in the crushed shape fails to adhere homogeneously.

WO 86/00842A1 discloses an apparatus for dispensing of solder paste for surface mounting of chip carriers on circuit boards. The apparatus comprises a tank for storing solder paste, a nozzle as a discharge pipe for the solder paste and a delivery pipe for fluid.

This invention is aimed at solving the problems mentioned above and providing a method for forming a solder layer of a soldered circuit board that avoids crushing the shape of solder powder, enables the solder powder to adhere homogenously to the circuit board and consequently realizes a fine circuit pattern and providing a device for discharge of the slurry containing the solder powder.

### Disclosure of the Invention:

The present invention provides as the first aspect a device for discharging a slurry containing solder powder, which is used for a method for forming a soldered circuit on a surface of a conductive circuit on a printed-wiring board comprising imparting tackiness to the surface, discharging the slurry containing solder powder to a resultant tacky part, thereby allowing adhesion of the solder powder thereto, and then heating the printed-wiring board, thereby fusing the solder, and which comprises a tank for storing the slurry, a slurry discharge and suction pipe disposed in the tank, and a delivery pipe and associated first pump for gas or solvent to be used for releasing the slurry stored in the tank via the slurry discharge and suction pipe, characterized in that the device also comprises a suction pipe and associated second pump for gas or solvent used for storing the slurry in the tank via the slurry discharge and suction pipe.

In the second aspect of the invention, the suction pipe and the delivery pipe for gas or solvent are provided with at least one of a pump and a switch valve.

The present invention further provides as the third aspect thereof a device for discharging slurry containing solder powder according to the first or second aspect, wherein the suction pipe and the delivery pipe are provided as a switching delivery pipe and associated reversible pump for gas or solvent to be used for suction of the slurry for storing the slurry in the tank via the slurry discharge and suction pipe and release of the slurry stored in the tank via the slurry discharge and suction pipe, the switching delivery pipe for gas or solvent being provided with a filter for allowing no passage of the solder powder, the filter being disposed in the lower part of the position at which the switching delivery pipe for gas or solvent is attached to the tank.

In the fourth aspect of the invention that includes the device of the third aspect, the switching delivery pipe for gas or solvent is provided with at least one of a pump capable of sucking and feeding gas or solvent and a switch valve.

When a soldered circuit board is configured by the use of the device of this invention for discharging slurry containing solder powder, since the solder particles supplied from the discharge device are homogenous in form, it becomes possible to form a fine soldered circuit pattern. Particularly, the use of this device is effective in homogenizing the thickness of a solder layer even in a fine circuit pattern, decreasing a short circuit with the solder metal between the adjacent circuit patterns and remarkably enhancing the reliability of a soldered circuit board. The method of this invention for forming a solder layer on a soldered circuit board renders it possible to realize the miniaturization of a circuit board having mounted electronic parts thereon and the impartation of high reliability thereto and consequently to provide an electronic machine excelling in special property.

The above and other objects, characteristic features and advantages of the present invention will become apparent to those skilled in the art from the description to be given herein below with reference the accompanying drawings.

### Brief Description of the Drawings:

FIG. 1 is one example of a device for discharging slurry containing solder powder (not according to this invention.)
FIG. 2 is an example of the device for discharging slurry containing solder powder according to this invention.
FIG. 3 is another example of the device for discharging slurry containing solder powder according to this invention.

### Best Mode for carrying out the Invention:

The printed-wiring boards coated with the device of this invention include plastic substrates, plastic film substrates, glass fabric substrates, paper-based epoxy resin substrates, substrates having a metal sheet stacked on a ceramic substrate, single-sided printed wiring boards and double-sided printed wiring boards having formed a circuit pattern by using a conductive substance, such as metal, on an insulating substrate resulting from coating a metal base with plastic or ceramic, and multiplayer printed wiring boards and flexible printed wiring boards, for example. This invention can also be applied to IC substrates, capacitors, resistors, coils, barristers, bare chips and wafers.

The device of this invention can be used for a method for forming a solder layer on a circuit board comprising causing the surface of a conductive circuit on the printed-wiring board to react with a tackifier compound to impart tackiness to the surface, applying solder powder to the resultant tacky part, and then heating the printed-wiring board, thereby fusing the solder powder.

As the substance for forming a circuit, copper is used in most cases. This invention does not need to limit this substance to copper and allows use of a conductive substance capable of enabling the surface to derive tackiness from the tackifier substances to be described herein below. As concrete examples of the substance, substances containing Ni, Sn, Ni-Au and solder alloy may be cited.

As the tackifier compounds used preferably, naphthotriazole-based derivatives, benzotriazole-based derivatives, imidazole-based derivatives, benzoimidazole-based derivatives, mercaptobenzothiazole-based derivatives and benzothiazolthio fatty acids may be cited. These tackifier compounds exhibit a strong effect particularly to copper and are capable of imparting tackiness to other conductive substances.

The benzotriazole-based derivatives are represented by general formula (1): 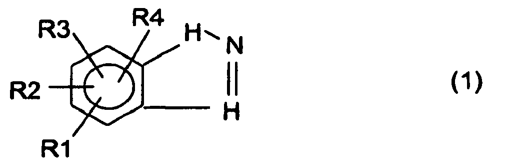 (wherein R1 to R4 independently denote a hydrogen atom, an alkyl group of 1 to 16, preferably 5 to 16 carbon atoms, an alkoxy group, F, Br, Cl, I, a cyano group, an amino group or an OH group).

The naphthotriaxole-based derivatives are represented by general formula (2): 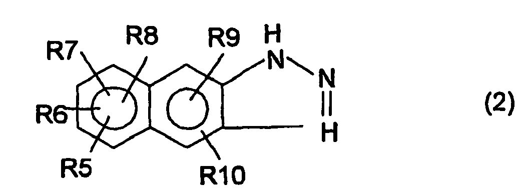 (wherein R5 to R10 independently denote a hydrogen atom, an alkyl group of 1 to 16, preferably 5 to 16 carbon atoms, an alkoxy group, F, Br, Cl, I, a cyano group, an amino group or an OH group).

The imidazole-based derivatives are represented by general formula (3): 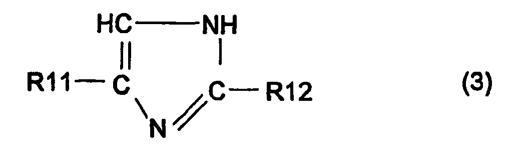 (wherein R11 and R12 independently denote a hydrogen atom, an alkyl group of 1 to 16, preferably 5 to 16 carbon atoms, an alkoxy group, F, Br, Cl, I, a cyano group, an amino group or an OH group).

The benzoimidazole-based derivatives are represented by formula (4): 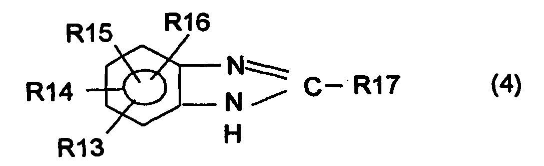 (wherein R13 to R17 independently denote a hydrogen atom, an alkyl group of 1 to 16, preferably 5 to 16 carbon atoms, an alkoxy group, F, Br, Cl, I, a cyano group, an amino group or an OH group).

The mercaptobenzothiazole-based derivatives are represented by general formula (5): 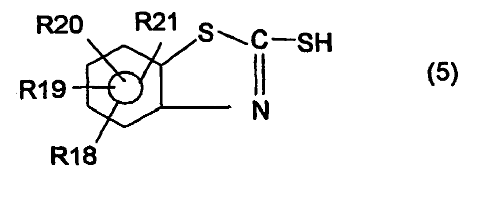 (wherein R18 to R21 independently denote a hydrogen atom, an alkyl group of 1 to 16, preferably 5 to 16 carbon atoms, an alkoxy group, F, Br, Cl, I, a cyano group, an amino group or an OH group).

The benzothiazolethio fatty acid-based derivatives are represented by general formula (6): 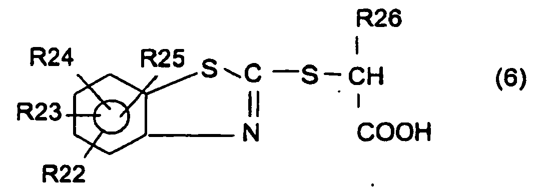 (wherein R22 to R26 independently denote a hydrogen atom, an alkyl group of 1 to 16, preferably 1 or 2 carbon atoms, an alkoxy group, F, Br, Cl, I, a cyano group, an amino group or an OH group).

Of these compounds, the benzotriazole-based derivatives represented by general formula (1) generally manifest strong tackiness in proportion as the carbon numbers of R1 to R4 increase.

The imidazole-based derivatives and the benzoimidazole-based derivatives represented by general formulae (3) and (4) generally manifest strong tackiness in proportion as the carbon numbers of R11 to R17 increase.

The benzothiazolthio fatty acid-based derivatives represented by general formula (6) prefer R22 to R26 to have 1 or 2 carbon atoms, respectively.

At least one of the tackifier compounds is dissolved in water or acid water and preferably adjusted to weak acidity of about pH 3 to pH 4 prior to use. As substances usable for the adjustment of pH when the conductive substance is a metal, inorganic acids including hydrochloric acid, sulfuric acid, nitric acid and phosphoric acid may be cited. The organic acids usable for this purpose include formic acid, acetic acid, propionic acid, malic acid, oxalic acid, malonic acid, succinic acid and tartaric acid. Though the concentration of the tackifier compound is not rigidly limited, but is properly adjusted, depending on the solubility and the condition of use, it is preferably in the range of 0.05 mass % to 20 mass % as a whole. If the concentration is lower than this range, the tacky film will not be formed sufficiently and will prove unsatisfactory in performance.

The temperature of the treatment prefers to be slightly elevated from room temperature for the sake of the speed and the amount of the formation of the tacky film. While it is not limited because it is variable with the concentration of the tackifier compound and the kind of the metal, it is generally proper in the range of 30°C to 60°C. While the duration of the immersion is not limited, it is preferable from the viewpoint of the efficiency of operation to adjust other conditions so that the duration may fall in the approximate range of 5 seconds to 30 minutes.

In this case, the presence of copper in a concentration of 30 to 1000 ppm as ions in the solution is advantageous in enhancing the efficiency of formation, such as the speed and the amount of the formation of the tacky film.

The printed-wiring board to be processed is preferably prepared in such a state that the solder-free conductive circuit part may be covered with resist, for example, and the circuit pattern will be alone left exposed and then subjected to a treatment with the solution of a tackifier compound.

The surface of the conductive circuit exhibits tackiness when the printed-wiring board is immersed in a solution of the tackifier compound used herein or the solution is applied to the surface.

The device of the present invention can be used for a method for discharging the slurry containing solder powder to the tacky part of the conductive circuit surface. In the case of inducing the adhesion of the solder powder to the tacky part of the circuit surface, a method that comprises immersing the printed-wiring board in the slurry, thereby causing the adhesion of the solder powder may be conceived. Since the solder powder is susceptible to buoyancy in the slurry as described previously, the adhesive force thereof may be low as compared with the dry process. When the discharge pipe is provided with a pump and a valve, these components will be at a disadvantage in crushing the solder particles.

This invention, therefore, is directed, on the occasion of causing the adhesion of the solder powder, to providing a device used in a method for discharging the slurry by dint of the pressure generated in the tank without requiring the discharge pipe to be provided with a pump or a valve. Thus, the slurry is pressed and the solder powder is caused to adhere fast to the circuit part to which tackiness has been imparted.

The adjustment of the pressure in this case is accomplished by feeding gas such as air, or water such as a solvent having the slurry dispersed therein, to the tank or releasing it from the tank. When the pressure is to be heightened, it suffices to feed gas into the tank. When the pressure is to be lowered, it suffices to discharge the gas from the tank. This pressure enables the speed of the discharge of the slurry to be controlled.

When causing the adhesion of solder powder to a circuit portion, there may be adopted a method of discharging slurry onto the circuit portion in a state in which a printed-wiring board has been immersed in water. When this method has been adopted, part of the solder powder in the discharged slurry, having not adhered to the circuit portion, can effectively be recovered without being solidified.

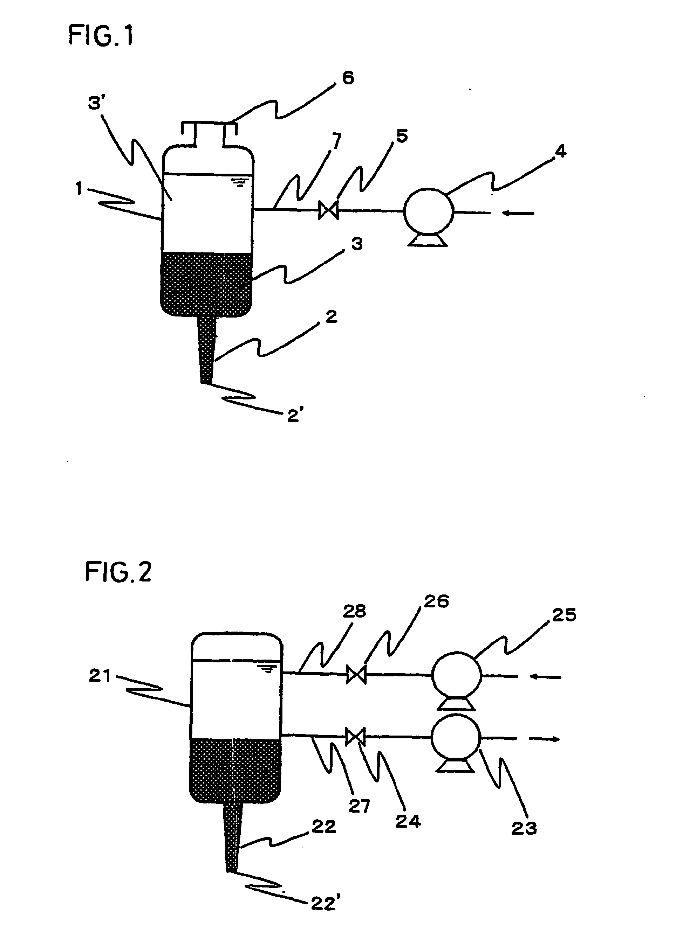

A device used for discharging the slurry containing solder powder is provided with a tank I for storing slurry 3 (in FIG. 1, the slurry is separated into a solder powder part and a solvent part in the tank), a slurry discharge pipe 2 disposed in the tank, a discharge port 2', a delivery pipe 7 connected to the tank and adapted to handle gas such as air or a solvent, and a pump 4 or switch valve 5 disposed in the delivery pipe and adapted to release the slurry stored in the tank via the discharge port. Reference numeral 6 denotes a supply port for supplying the slurry containing solder power to the tank 1. Such a device and Fig. 1 do not form part of the present invention, but are included here for the understanding of the invention.

In the device shown in FIG. 1, the slurry introduced into the tank 1 via the supply port 6 is released via the slurry discharge pipe 2 by pressing the tank 1 with the compressed air supplied by the pump 4 and the switch valve 5 or the solvent constituting the slurry. According to the slurry discharge device of this configuration, it is made possible to supply the solder powder stable in shape because the solder powder contained in the slurry does not pass the pump and the switch valve and has no possibility of being crushed by the machine parts, such as the pump and the switch valve.

A device for discharging a slurry containing solder powder according to this invention, as shown in FIG. 2, is provided with a tank 21 for storing the slurry, a slurry discharge and suction pipe 22 disposed in the tank and used for discharge of the slurry and suction of the slurry in common, a suction pipe 27 for the air to be used for sucking the slurry via the discharge and suction pipe 22 and storing it in the tank 21, a first pump 23 and a switch valve 24 disposed in the suction pipe 27, a delivery pipe 28 for the air to be used for releasing the slurry stored in the tank via the discharge port, and a second pump 25 and a switch valve 26 disposed in the delivery pipe 28.

In the device of this configuration, the slurry introduced into the tank 21 via the discharge and suction pipe 22 can be released via a port 22' of the discharge and suction pipe 22 by pressing the tank with the compressed air supplied by the second pump 25 and the second switch valve 26 or the solvent constituting the slurry.

According to the slurry discharge device of the configuration described above, it is made possible to supply the solder powder stable in shape because the solder powder contained in the slurry stored in the tank does not pass the pump and the switch valve and has no possibility of being crushed by the machine parts, such as the pump and the switch valve.

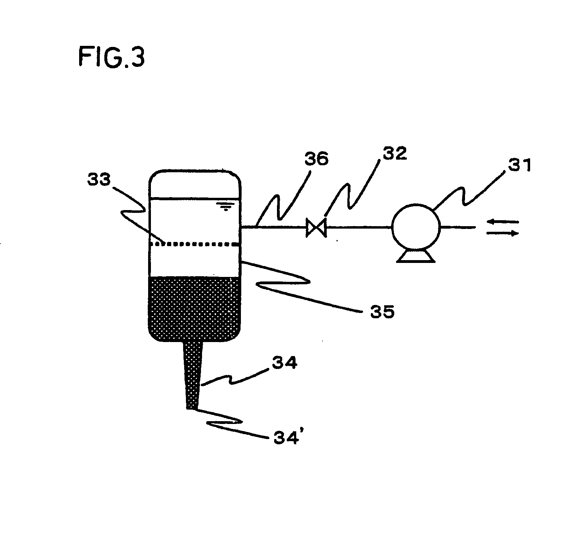

The discharge device used for the slurry containing solder powder and configured as illustrated in FIG. 2 may be modified to a configuration which, as shown in FIG. 3, has the suction pipe as for air, the delivery pipe, the first pump and the first switch valve and the second pump and the second switch valve disposed therein consolidated into an assembly consisting of a switching delivery pipe 36 as for air, a pump 31 and a valve 32 plus a filter 33 allowing no passage of the solder powder in the tank. The filter is disposed in the lower part of the position at which a switching delivery pipe 36 is attached to the tank. Thus, the solder powder has no possibility of passing the pump 31 and the valve 32. In this device, the operation of sucking and discharging the slurry via a discharge and suction port 34' of a discharge and suction pipe 34 is carried out by reversing the motion of the pump 31 and the possibility that the solder powder stored in a tank 35 will flow into the pump 31 and the switch valve 32 and consequently the solder powder will be crushed by the machine parts, such as the pump and the switch valve, is nil. By the device of this configuration, it is made possible to supply the solder powder stable in shape.

In the method that forms a solder circuit by imparting tackiness to the surface of a conductive circuit on a printed-wiring board, causing the slurry containing solder powder to be discharged to the resultant tacky part, thereby inducing adhesion of the solder power thereto, and then heating the printed-wiring board, thereby fusing the solder powder, the use of the discharge device described above can materialize a method for forming a solder circuit that does not pass the solder powder through the pump or the switch valve in the discharging device.

In the slurry containing the solder powder that is used for this invention, the concentration of the solder powder in the slurry is set preferably in the range of 0.5 volume % to 10 volume % and more preferably in the range of 3 volume % to 8 volume %.

The slurry containing the solder powder that is used in this invention prefers to use water as its solvent. For the purpose of preventing the solder powder from being oxidized with water, it is favorable to use deoxidized water or add corrosion inhibitor to the water.

The method of the treatment contemplated by this invention can be effectively used not only for the aforementioned solder precoat circuit board but also for the formation of bumps aimed at joining a BGA (ball grid array) or a CSP (chip size package). These are naturally embraced in the solder circuit board contemplated by this invention.

The metallic compositions for the solder powder to be used in the method for producing the solder circuit board include Sn-Pb-based, Sn-Pb-Ag-based, Sn-Pb-Bi-based, Sn-Pb-Bi-Ag-based and Sn-Pb-Cd-based compositions, for example. From the recent viewpoint of excluding Pb from industrial wastes, Sn-In-based, Sn-Bi-based, In-Ag-based, In-Bi-based, Sn-Zn-based, Sn-Ag-based, Sn-Cu-based, Sn-Sb-based, Sn-Au-based, Sn-Bi-Ag-Cu-based, Sn-Ge-based, Sn-Bi-Cu-based, Sn-Cu-Sb-Ag-based, Sn-Ag-Zn-based, Sn-Cu-Ag-based, Sn-Bi-Sb-based, Sn-Bi-Sb-Zn-based, Sn-Bi-Cu-Zn-based, Sn-Ag-Sb-based, Sn-Ag-Sb-Zn-based, Sn-Ag-Cu-Zn-based and Sn-Zn-Bi-based compositions each containing no Pb are preferably used.

As concrete examples of the foregoing metallic compositions, the eutectic solder consisting of 63 mass % of Sn and 37 mass % of Pb (hereinafter expressed as 63Sn-37Pb) and playing a central role, 62Sn-36Pb-2Ag, 62.6Sn-37Pb-0.4Ag, 60Sn-40Pb, 50Sn-50Pb, 30Sn-70Pb, 25Sn-75Pb, 10Sn-88Pb-2Ag, 46Sn-8Bi-46Pb, 57Sn-3Bi-40Pb, 42Sn-42Pb-14Bi-2Ag, 45Sn-40Pb-15Bi, 50Sn-32Pb-18Cd, 48Sn-52In, 43Sn-57Bi, 97In-3Ag, 58Sn-42In, 95In-5Bi, 60Sn-40Bi, 91Sn-9Zn, 96.5Sn-3.5Ag, 99.3Sn-0.7Cu, 95Sn-5Sb, 20Sn-80Au, 90Sn-10Ag, 90Sn-7.5Bi-2Ag-0.5Cu, 97Sn-3Cu, 99Sn-1Ge, 92Sn-7.5Bi-0.5Cu, 97Sn-2Cu-0.8Sb-0.2Ag, 95.5Sn-3.5Ag-1Zn, 95.5Sn-4Cu-0.5Ag, 52Sn-45Bi-3Sb, 51Sn-45Bi-3Sb-1Zn, 85Sn-10Bi-5Sb, 84Sn-10Bi-5Sb-lZn, 88.2Sn-10Bi-0.8Cu-1Zn, 89Sn-4Ag-7Sb, 88Sn-4Ag-7Sb-1Zn, 98Sn-1Ag-1Sb, 97Sn-1Ag-1Sb-1Zn, 91.2Sn-2Ag-0.8Cu-6Zn, 89Sn-8Zn-3Bi, 86Sn-8Zn-6Bi and 89.1 Sn-2Ag-0.9Cu-8Zn are cited. The solder powder to be used may be a mixture of two or more different compositions.

Since the thickness of the solder film to be formed can be adjusted by varying the particle diameter of the solder powder, the particle diameter of the solder powder is selected based on the thickness of the solder coat. Japanese Industrial Standards (JIS), for example, select the thickness from the powders having specified diameters in the ranges of 63 to 22 µm, 45 to 22 µm and 38 to 22 µm determined by screening and balls having diameters exceeding 80 µm. For the determination of the average particle diameter of the solder powder of this invention, the method that uses a standard sieve and a simple balance as specified by JIS can be adopted. The determination may be otherwise accomplished by the image analysis with a microscope or a Coulter counter based on the electrozone method. As regards the Coulter counter, the principle thereof is entered in "Powder Technology Handbook" (compiled by the Society of Powder Technology, Japan, 2nd edition, pp 19-20). This counter determines the particle diameter distribution of powder by causing a solution having the powder dispersed therein to pass through a fine hole opened in a diaphragm and measuring the change in electric resistance on both sides of the fine hole. It can determine the ratio of pieces of particle diameter with high repeatability. The average particle diameter of the solder powder of this invention can be determined by using the method described above.

The solder circuit board fabricated using the device of this invention can be advantageously used for the method of mounting electronic parts that comprises the steps of mounting electronic parts and joining the electronic parts by reflowing solder. The electronic parts can be joined to the parts of the solder circuit board fabricated by the device of this invention that require their adhesion by applying solder paste to the parts as by the printing method, mounting the electronic parts in position, then heating them, thereby fusing the solder powder in the solder paste, and hardening the fused solder powder, for example.

As a means for joining the electronic parts to the solder circuit board, the surface-mount technology (SMT) may be used. This mounting method starts from preparing a solder circuit board by this invention or by the method for printing the solder paste. The solder paste is applied to the portions of the circuit pattern that require adhesion of electronic parts. Then the electronic parts, such as chip parts and QFP, to which solder has been attached or reflowed by the method of this invention are mounted on the solder paste of the circuit pattern and are collectively soldered thereto by the heat source of reflow. As the heat sources of reflow, an air-heating furnace, an infrared furnace, condensation soldering equipment and light beam soldering equipment may be used.

In the process of reflow, the preheating temperature is 130 to 180°C, preferably 130 to 150°C, and the preheating time is 60 to 120 seconds, preferably 60 to 90 seconds. The reflow temperature is +20 to +50°C based on the melting point of the alloy to be used, preferably +20 to +30°C based on the melting point of the alloy, and the reflow time is 30 to 60 seconds, preferably 30 to 40 seconds.

The reflow process can be carried out in nitrogen or in the air. In the case of the nitrogen reflow, by keeping the oxygen concentration of 5 volume % or less, preferably 0.5 volume % or less, it is made possible to enhance the wettability of the solder circuit with the solder and reduce the occurrence of solder balls as compared with the air reflow and ensue stable treatment.

Thereafter, the solder circuit board is cooled to complete the surface mounting. The method for the production of electronic part joints according to this method of mounting may be carried out on both sides of a printed-wiring board. As the electronic parts that can be used for the method for mounting electronic parts, LSI, resistors, capacitors, transformers, inductances, filters, oscillators and transducers may be cited, though not exclusively.

Now, this invention will be described with reference to an example. It is nevertheless not limited to the example.

### Example:

A printed-wiring board having the minimum electrode interval of 50 µm and an electrode diameter of 80 µm was fabricated. Copper was used for a conductive circuit.

As the tackifier compound solution, a 2 mass % aqueous solution of an imidazole-based compound having C₁₁H₂₃ as the alkyl group of R12 and a hydrogen atom as R1 1 in general formula (3) was adjusted to a pH of about 4 with acetic acid prior to use. This aqueous solution was heated to 40°C. In the heated aqueous solution, the printed-wiring board pretreated with an aqueous hydrochloric acid solution was immersed for three minutes to form a tacky substance on the surface of the copper circuit.

The slurry containing solder powder was produced by mixing about 20 g of solder powder of 96.5Sn-3.5Ag having an average particle diameter of 70 µm (the average particle diameter of the solder powder determined by the use of a Microtrac®) with about 100 g of deoxidized pure water.

The device used for discharging the slurry containing the solder powder was configured as illustrated in FIG. 2.

The slurry containing the solder powder produced as described above was sucked via the slurry discharge and suction pipe 22 in FIG. 2 into the tank 21 by opening the switch valve 24. Then, the discharge port 22' was set on the substrate to which tackiness had been imparted. This time, the switch valve 26 was opened to discharge the slurry containing the solder powder so as to cover the substrate.

Subsequently, the excess solder powder existing on the substrate was rinsed with pure water and the wet substrate was dried.

The powder so rinsed was recovered and used again for the attachment of solder powder.

The printed-wiring board was placed in an oven at 240°C to fuse the solder powder and form solder bumps of 96.5Sn-3.5Ag in a thickness of about 50 µm on the copper circuit part. In the soldered circuit, bridges and the like were not formed at all.

### Industrial Applicability:

In a method for producing an electronic circuit board by imparting tackiness to a metal exposed part on a substrate, thereby inducing adhesion of solder powder to the taky part, and then heating the printed-wiring board, thereby fusing the solder and forming a soldered circuit, using a device of this invention a method that enables production of an electronic circuit board of markedly enhanced reliability while effectively reducing the short circuit with the solder metal between the adjacent circuit patterns even in a fine circuit pattern has been perfected. As a result, a circuit board possessing a fine circuit pattern, manifesting high reliability and having mounted circuit parts allows miniaturization and impartation of high reliability. Thus, it is made possible to provide an electronic circuit board, a circuit board having mounted electronic parts exhibiting high reliability and realizing high mounting density, and an electronic device of excellent characteristics.

## Claims

1. A device for discharging a slurry containing solder powder, which is used for a method for forming a soldered circuit on a surface of a conductive circuit on a printed-wiring board comprising imparting tackiness to the surface, discharging the slurry containing solder powder to a resulting tacky part, thereby allowing adhesion of the solder powder thereto, and then heating the printed-wiring board, thereby fusing the solder, and which comprises a tank (21) for storing the slurry, a slurry discharge and suction pipe (22) disposed in the tank (21), and a delivery pipe (28) and associated first pump (25) for gas or solvent to be used for releasing the slurry stored in the tank (21) via the slurry discharge and suction pipe (22), **characterized in that** the device also comprises a suction pipe (27) and associated second pump (23) for gas or solvent used for storing the slurry in the tank (21) via the slurry discharge and suction pipe (22).

2. A device for discharging a slurry according to claim 1, wherein the suction pipe (27) and the delivery pipe (28) for gas or solvent are provided with at least one of a pump (23, 25) and a switch valve (24, 26).

3. A device for discharging a slurry containing solder powder, which is used for a method for forming a soldered circuit on a surface of a conductive circuit on a printed-wiring board comprising imparting tackiness to the surface, discharging the slurry containing solder powder to a resulting tacky part, thereby allowing adhesion of the solder powder thereto, and then heating the printed-wiring board, thereby fusing the solder, and which comprises a tank (35) for storing the slurry, and a slurry discharge and suction pipe (34), **characterized in that** the device also includes a switching delivery pipe (36) and associated reversible pump (31) for gas or solvent to be used for suction of the slurry for storing the slurry in the tank (35) via the slurry discharge and suction pipe (34) and release of the slurry stored in the tank (35) via the slurry discharge and suction pipe (34), the switching delivery pipe (36) for gas or solvent being provided with a filter (33) allowing no passage of the solder powder, the filter being disposed in the lower part of the position at which the switching delivery pipe (36) for gas or solvent is attached to the tank (35).

4. A device for discharging a slurry containing solder powder according to claim 3, wherein the switching delivery pipe (36) for gas or solvent is provided with at least one of a pump (31) capable of sucking and feeding gas or solvent and a switch valve (32).

## Patentansprüche

1. Vorrichtung zum Abgeben einer Lötpulver enthaltenden Aufschlämmung, die für ein Verfahren zum Bilden einer gelöteten Schaltung auf einer Oberfläche eines Schaltkreises auf einer Leiterplatte eingesetzt wird, welches das Übertragen von Klebrigkeit auf die Oberfläche, das Abgeben der das Lötpulver enthaltenden Aufschlämmung in den erhaltenen klebrigen Bereich, wodurch die Anhaftung des Lötpulvers an diesen zugelassen wird, und dann das Erwärmen der Leiterplatte umfasst, wodurch das Lot verschmolzen wird, und welche einen Behälter (21) zum Lagern der Aufschlämmung, eine in dem Behälter (21) angebrachte Leitung (22) zum Abgeben und Saugen der Aufschlämmung und eine Zuführleitung (28) und eine verbundene erste Pumpe (25) für Gas oder Lösungsmittel umfaßt, das für die Freisetzung der in dem Behälter (21) gelagerten Aufschlämmung über die Leitung (22) zum Abgeben und Saugen der Aufschlämmung eingesetzt werden soll, **dadurch gekennzeichnet, dass** die Vorrichtung auch eine Saugleitung (27) und eine verbundene zweite Pumpe (23) für Gas oder Lösungsmittel umfaßt, das für das Lagern der Aufschlämmung in dem Behälter (21) über die Leitung (22) zum Abgeben und Saugen der Aufschlämmung eingesetzt wird.

2. Vorrichtung zum Abgeben einer Aufschlämmung nach Anspruch 1, wobei die Saugleitung (27) und die Zuführleitung (28) für Gas oder Lösungsmittel mit mindestens einer Pumpe (23, 25) und einem Schaltventil (24, 26) ausgestattet sind.

3. Vorrichtung zum Abgeben einer Lötpulver enthaltenden Aufschlämmung, die für ein Verfahren zum Bilden einer gelöteten Schaltung auf einer Oberfläche eines Schaltkreises auf einer Leiterplatte eingesetzt wird, welches das Übertragen von Klebrigkeit auf die Oberfläche, das Abgeben der Lötpulver enthaltenden Aufschlämmung in den erhaltenen klebrigen Bereich, wodurch die Anhaftung des Lötpulvers daran zugelassen wird, und dann das Erwärmen der Leiterplatte umfasst, wodurch das Lot verschmolzen wird, und welche einen Behälter (35) zum Lagern der Aufschlämmung und eine Leitung (34) zum Abgeben und Saugen der Aufschlämmung umfasst, **dadurch gekennzeichnet, dass** die Vorrichtung ebenfalls eine umschaltbare Zuführleitung (36) und eine verbundene reversible Pumpe (31) für Gas oder Lösungsmittel umfaßt, das für das Saugen der Aufschlämmung über die Leitung (34) zum Abgeben und Saugen der Aufschlämmung zum Lagern der Aufschlämmung in dem Behälter (35) und für die Freisetzung der in dem Behälter (35) gelagerten Aufschlämmung über die Leitung (34) zum Abgeben und Saugen der Aufschlämmung eingesetzt werden soll, wobei die umschaltbare Zuführleitung (36) für Gas oder Lösungsmittel mit einem Filter (33) versehen ist, der keinen Durchgang des Lötpulvers erlaubt, wobei der Filter an dem unteren Teil der Position, an der die umschaltbare Zuführleitung (36) für Gas oder Lösungsmittel mit dem Behälter (35) verbunden ist, angebracht ist.

4. Vorrichtung zum Abgeben einer Lötpulver enthaltenden Aufschlämmung nach Anspruch 3, wobei die um schaltbare Zuführleitung (36) für Gas oder Lösungsmittel mit mindestens einer Pumpe (31), die Gas oder Lösungsmittel saugen oder zuführen kann, und einem Schaltventil (32) versehen ist.

## Revendications

1. Dispositif pour l'évacuation d'une pâte contenant de la poudre de soudure, qui est utilisée pour un procédé destiné à former un circuit soudé sur une surface d'un circuit conducteur sur une plaque de circuit imprimé comportant le fait de donner un caractère collant à la surface, de délivrer la pâte contenant de la poudre de soudure sur une partie collante résultante, en permettant ainsi l'adhésion de la poudre de soudure dessus, et de chauffer ensuite la plaque de circuit imprimé, en fondant ainsi la soudure, et qui comporte un réservoir (21) pour le stockage de la pâte, un tuyau d'évacuation et d'aspiration de pâte (22) disposé dans le réservoir (21), et un tuyau de sortie (28) et une première pompe associée (25) pour du gaz ou du solvant devant être utilisé pour libérer la pâte stockée dans le réservoir (21) en passant par le tuyau d'évacuation et d'aspiration de pâte (22), **caractérisé en ce que** le dispositif comporte également un tube d'aspiration (27) et une deuxième pompe associée (23) pour du gaz ou du solvant utilisé pour le stockage de la pâte dans le réservoir (21) en passant par le tuyau d'évacuation et d'aspiration de pâte (22).

2. Dispositif pour l'évacuation d'une pâte selon la revendication 1, dans lequel le tube d'aspiration (27) et le tuyau de sortie (28) pour du gaz ou du solvant sont pourvus d'au moins une d'une pompe (23, 25) et d'une soupape de commutation (24, 26).

3. Dispositif pour l'évacuation d'une pâte contenant de la poudre de soudure, qui est utilisée pour un procédé destiné à former un circuit soudé sur une surface d'un circuit conducteur sur une plaque de circuit imprimé comportant le fait de donner un caractère collant à la surface, de délivrer la pâte contenant de la poudre de soudure sur une partie collante résultante, en permettant ainsi l'adhésion de la poudre de soudure dessus, et de chauffer ensuite la plaque de circuit imprimé, en fondant ainsi la soudure, et qui comporte un réservoir (35) pour le stockage de la pâte, et un tuyau d'évacuation et d'aspiration de pâte (34), **caractérisé en ce que** le dispositif comprend également un tuyau de sortie de commutation (36) et une pompe réversible associée (31) pour du gaz ou du solvant devant être utilisé pour l'aspiration de la pâte afin de stocker la pâte dans le réservoir (35) en passant par le tuyau d'évacuation et d'aspiration de pâte (34) et libérer la pâte stockée dans le réservoir (35) en passant par le tuyau d'évacuation et d'aspiration de pâte (34), le tuyau de sortie de commutation (36) pour du gaz ou du solvant étant pourvu d'un filtre (33) ne permettant pas de passage de la poudre de soudure, le filtre étant disposé dans la partie inférieure de la position dans laquelle le tuyau de sortie de commutation (36) pour du gaz ou du solvant est fixé sur le réservoir (35).

4. Dispositif pour l'évacuation d'une pâte contenant de la poudre de soudure selon la revendication 3, dans lequel le tuyau de sortie de commutation (36) pour du gaz ou du solvant est pourvu d'au moins une d'une pompe (31) capable d'aspirer et de délivrer du gaz ou du solvant et d'une soupape de commutation (32).
